# EUROPEAN PATENT APPLICATION

(11) **EP 4 687 401 A1**
(43) Date of publication of application: **04.02.2026**
(21) Application number: 24191481.1
(22) Date of filing: 29.07.2024
(51) Int. Cl.: H10F 19/40

(54) **MICRO-STRUCTURED PATTERNED BONDED LAYER FOR TANDEM SOLAR CELLS**

(71) Applicant: Institut Photovoltaique d'Ile de France, 91120 Palaiseau (FR); Electricité de France, 75008 Paris (FR); Riber, 95870 Bezons (FR); Centre National de la Recherche Scientifique, 75016 Paris (FR); Ecole Polytechnique, 91120 Palaiseau (FR)
(72) Inventor: BUENCUERPO FARINA, Jerónimo, 28232 Madrid (ES); COLLIN, Stéphane, 94230 Cachan (FR); CATTONI, Andrea, 20088 Rosate (IT)
(74) Representative: Axe PI

(57) **Abstract**

The invention relates to α tandem photovoltaic cell, comprising a rear junction layer (2) with a first light absorption spectrum and a front junction layer (4) with a second light absorption spectrum, and a bonding layer (6) located between them, the bonding layer (6) being of a transparent and conductive material, wherein the material of the at least one bonding layer (6) comprises among a filler (8) a distribution of microscopic studs (10) linking the top of the at least one rear junction layer (2) and the bottom of the front junction layer (4).

The invention also relates to a photovoltaic panel with such a cell, and to production methods of such a cell.

## Description

### TECHNICAL FIELD

The present invention relates to a tandem photovoltaic cell and a photovoltaic panel comprising several of the tandem photovoltaic cells. The invention also relates to production methods of the tandem photovoltaic cells.

It is well known that photovoltaic panels convert sunlight into electricity using photovoltaic cells. Such a photovoltaic panel comprises several photovoltaic cells arranged side by side into a matrix configuration to form a grid.

A photovoltaic cell can be of many different types, especially of a tandem type.

A tandem type of a photovoltaic cell, or "tandem photovoltaic cell", comprises at least two junction layers: a rear junction layer and a front junction layer assembled together by an intermediate layer which bonds the rear and front layer. So an intermediate layer is so-called a "bonding layer".

Moreover, the rear junction layer and the front junction layer have two different light absorption spectrums, in order to convert the light energy of each of the two spectrums from sunlight. So the bonding layer must have a material with a required transparency which allows the light to reach the rear junction layer. The bonding layer material must also be conductive. Such a bonding material is also called "TCL" for "Transparent Conductive Layer".

One of the difficulties of a tandem cell is therefore to obtain an assembly between the two photovoltaic junction layers allowing electrical conduction between them, while maximizing the transparency of the connection between them.

### BACKGROUND ART

A known solution resides in a tandem photovoltaic cell with two junction layers which are stacked on top of each other by "direct bonding", that is to say without additional intermediate layers. In order to allow such direct bonding, the corresponding top and bottom contact surfaces of the two junction layers must be treated in such a way to allow bonding between the two junction layers. This surface treatment requires significant resources, in particular perfectly flat and non-rough surfaces, free of particles, and under a controlled atmosphere in case the surfaces require surface activation to promote bonding.

Another solution is known from the document FR3118531, which describes a tandem photovoltaic cell comprising a bonding layer made of a stacking of several layers.

In particular, such a tandem photovoltaic cell comprises a rear cell having a first light absorption spectrum associated with a first type of photon and a front cell having a second light absorption spectrum associated with a second type of photon, whose energy level is higher than the photons of the first type. The photovoltaic cell also comprises a plurality of transparent conductive layers ensuring bonding between the front cell and the rear cell.

Such bonding layers comprise a first and a second layer of a first type whose optical index of refraction is greater than 1.8, the thickness is such that the product of the thickness by the optical index is between 150nm and 250nm and configured to be arranged respectively in contact with the front cell and the rear cell. The bonding layers also comprise a first and a second layer of a second type based on a flexible transparent conductive mesoporous material whose pore diameter is less than 100nm and whose optical refractive index is less than 1.7, the said first and second layers of a second type being configured to be arranged respectively in contact with the first and second layers of the first type. The bonding layers further comprise a layer of a third type based on a flexible transparent conductive material whose optical refractive index is less than 1.7 and placed between the first and second layers of the second type and configured to allow adhesion between the first and second layers of the second type.

However, the thickness of the multi-layer bonding layer is important and difficult to produce.

So a problem to be solved resides in providing a bonding layer material with a thickness as thin as possible, to have a required transparency, and also required conductive characteristics depending on the junction layers.

Moreover, the bonding layer material must bond together the junction layers well, with good mechanical stability and compatibility with the roughness of the corresponding surfaces.

Also the bonding layer material must enable later separation of the junction layers for better recycling of the photovoltaic cell.

### SUMMARY OF THE INVENTION

An object of the present invention is to improve a tandem photovoltaic cell, with a bonding layer which is thinner, to be more transparent and also more conductive, but still fits the requirements of perfectly bonding together the top junction layer and the bottom junction layer, even in the case of rough or textured rear or front junction layers.

Such characteristics of the bonding layer are obtained through a micro-structured configuration, creating a bonding mesh on the surface of the material.

Therefore, according to the invention, the tandem photovoltaic cell comprises:
- at least one rear junction layer with a first light absorption spectrum associated with a first type of photon;
- at least one front junction layer with a second light absorption spectrum associated with a second type of photon;
- at least one bonding layer located between the at least one rear junction layer and the at least one front junction layer,

a bottom surface of the at least one bonding layer bonding a top of the at least one rear layer,
a top surface of the at least one bonding layer bonding a bottom of the at least one front layer,
the at least one bonding layer being of a transparent and conductive material.

Such a tandem photovoltaic cell is characterized in that the material of the at least one bonding layer comprises among a filler a distribution of microscopic studs linking the top of the at least one rear junction layer and the bottom of the front junction layer.

According to an embodiment, the microscopic studs globally have a hollow tube shape.

According to an embodiment, the microscopic studs globally have a height comprised between 1 microns (µm) and 100 microns (µm).

According to an embodiment, the microscopic studs globally have a diameter up to 200 microns (µm), especially less than 100 microns (µm), preferably around 50 microns (µm).

According to an embodiment, the microscopic stud distribution is regular with a matrix configuration.

According to an embodiment, the microscopic studs of the matrix configuration distribution have a spacing less than 1 millimeter (mm), preferably between 100 microns (µm) and 200 microns (µm).

According to an embodiment, the microscopic stud distribution is irregular, the microscopic studs being randomly distributed among the filler.

According to an embodiment, the bottom end inside the hollow tube shape studs is covered with the same material as the material of the studs.

According to an embodiment, the top ends of the hollow tube shape studs are linked by a coating with the same material as the material of the studs.

According to an embodiment, the inside of the hollow tube shape of the studs is filled with a transparent material, which is conductive or non-conductive, preferably with the same material as the filler.

According to an embodiment, the filler between the studs comprises a non-conductive and transparent material, preferably made of PMMA or PDMS or photoresist.

According to an embodiment, the material of the microscopic studs is PEDOT:PSS.

The invention also relates to a photovoltaic panel comprising several of the tandem photovoltaic cells.

According to the invention, the photovoltaic panel comprises:
- at least one module for generating electricity by converting sunlight,
   characterized in that
- each module comprising several tandem photovoltaic cells according to any of the preceding claims, the tandem photovoltaic cells being arranged side by side.

The invention also relates to a first production method of the photovoltaic cell, comprising the steps of:
- defining the microscopic stud distribution by printing the microscopic stud distribution on the bottom of the front junction layer or on the top of the rear junction layer with a polymer material, such as PMMA, PDMS, or a photoresist material;
- coating the pattern with PEDOT:PSS;
- printing the microscopic stud distribution on the bottom of the front junction layer or on the top of the rear junction layer with PEDOT:PSS;
- treating the printed surface by a soft crystallization technique with low temperatures comprised between 0°C and 200°C (degree Celsius);
- bonding the corresponding top of the rear junction layer or bottom of the front junction layer.

According to an embodiment, the production method comprising the step of printing consists in a lithography technique or an inkjet technique.

According to an embodiment, the production method comprises a lift-off of the coated surface by removing the filler through immersion in a compatible solvent chosen from acetone, EtOH or similar, to create a stud surrounded by air.

The invention also relates to a second production method of the tandem photovoltaic cell, comprising the steps of:
- applying a mixed material of PEDOT:PSS with a solvent, such as PMMA, PDMS, diluted in toluene, or PGMEA, on the bottom of the front junction layer or on the top of the rear junction layer;
- coating the mixed material on the top of the rear junction layer or on the bottom of the front junction layer;
- to obtain the coated surface, evaporate the solvent to create the microscopic stud distribution, through spreading the coating and/or applying a heating technique;
- treating the coated surface by a soft crystallization technique at low temperatures comprised between 0°C and 200°C;
- bonding the corresponding top of the rear junction layer or bottom of the front junction layer.

The invention also relates to a third production method of the photovoltaic cell, comprising the steps of:
- applying a mixed material of two polymers, such as PMMA, PS or PDMS, diluted in a solvent, such as PGMEA or toluene, on the bottom of the front junction layer or on the top of the rear junction layer;
- evaporate the solvent to create the microscopic stud distribution, through spreading the coating and/or applying a heating technique;
- remove selectively one of the two transparent polymers with a selective solvent;
- coating the random pattern with PEDOT:PSS into a coated surface;
- treating the coated surface by a soft crystallization technique at low temperatures comprised between 0°C and 200°C;
- bonding the corresponding top of the rear junction layer or bottom of the front junction layer.

### BRIEF DESCRIPTION OF THE DRAWINGS

The invention shall be better understood when reading the following non-restricted description, with reference to the accompanying drawings, wherein:
Figure 1 is a diagrammatical perspective view of an embodiment of a solar photovoltaic panel, including a zoom of a photovoltaic cell;
Figure 2 is a diagrammatical view of a photovoltaic cell with several layers including a middle bonding layer, and cross horizontal and vertical section views of the bonding material, showing different embodiments of the distribution of the material of the bonding layer, especially of the microscopic studs;
Figure 3 is a diagrammatical vertical cross section view of a first embodiment of the material of the bonding layer, especially showing a hollow tube shape of the studs located inside the material of the filler and linking the top of the rear junction layer and the bottom of the bottom of the front junction material;
Figure 4 is a diagrammatical vertical cross section view of a second embodiment of the material of the bonding layer, especially showing a hollow tube shape of the studs with a bottom end inside, covered with the same material;
Figure 5 is a diagrammatical vertical cross section view of a third embodiment of the material of the bonding layer, especially showing a hollow tube shape of the studs with top ends linked by a coating of the same material;
Figure 6 is a diagrammatical vertical cross section view of a fourth embodiment of the material of the bonding layer, especially showing a hollow tube shape of the studs with both bottom ends inside and top ends linked by a coating of the same material;
Figure 7 is a diagrammatical vertical cross section view of a fifth embodiment of the material of the bonding layer, especially showing a hollow tube shape of the studs with both bottom ends inside and top ends linked by a coating of the same material, and also the inside of the hollow tube shape filled with a transparent material;
Figure 8 is a microscopic photographic top view of an irregular configuration of the stud distribution of the bonding layer material;
Figure 9 is a microscopic photographic top view of a matrix configuration of the stud distribution on the surface of the bonding layer material;
Figure 10 is a microscopic zoom of a stud, before bonding the junction layers with the bonding layer;
Figure 11 is a microscopic zoom of a stud of the matrix configuration of the stud distribution, after bonding; and
Figure 12 is a perspective microscopic zoom of a stud, especially showing the tube shape of the stud.

### DESCRIPTION OF EMBODIMENTS

The invention relates to a tandem photovoltaic cell 1, or« cell 1 ».

Several cells 1 can be combined to make a photovoltaic panel 100. In other words, the cell 1 is part of a photovoltaic panel 100.

The invention also relates to a photovoltaic panel 100, comprising at least one module for generating electricity by converting sunlight, each module comprising several of the tandem photovoltaic cells 1 being arranged side by side. Especially, the cells 1 are electrically connected through dedicated links or strings.

According to an embodiment, the panel 100 comprises several cells 1 arranged into a grid pattern, alike a matrix configuration along rows and columns.

Furthermore, the cell 1 is of a tandem type, also called « multi-junction cell». So the cell 1 can comprise several junction layers, associated with different light absorption spectrums associated with different types of photons.

In particular, the cell 1 comprises the corresponding number of terminals depending on the type of the tandem type, depending on the number of terminals connected to the junction layers of the cell 1. So the cell 1 can comprise two junction layers for a 2T tandem type, three junction layers for a 3T tandem type, or four junctions layers for a 4T tandem type.

For example, a multi-junction cell 1 can comprise two or more vertically stacked cells with successive bandgaps: one at 1.8 eV, 1.4, eV and 1.12 eV, and each of the stacked cells are independently working as a two-terminals (2T) or as a three-terminals (3T).

According to the invention, the cell 1 comprises at least two junction layers. So the cell 1 can comprise two or more junction layers.

Especially, the cell 1 comprises at least one rear junction layer 2 with a first light absorption spectrum associated with a first type of photon. The cell 1 also comprises at least one front junction layer 4 with a second light absorption spectrum associated with a second type of photon.

So the front junction layer 4 is located at the top of the cell 1, above the rear junction layer 2 which is located at the bottom.

As aforementioned, more junction layers can be added to the cell 1, over or under one of the rear junction layers 4 and/or of the front junction layer 6.

Then, the cell 1 also comprises at least one bonding layer 6 located between the at least one rear junction layer 4 and the at least one front junction layer 6. Such a bonding layer 6 is dedicated to solidarize or "glue" the junction layers 4,6 together. Especially, a bottom surface of the at least one bonding layer 6 is bonding a top of the at least one rear junction layer 2 and a top surface of the at least one bonding layer 6 is bonding a bottom of the at least one front junction layer 4.

Thus being, in order to allow the light to get through the bonding layer 6 and to reach the rear junction layer(s) 2, said at least one bonding layer 6 is made of a transparent material. Moreover, the material of the bonding layer 6 is made of a conductive material.

So, the material of the bonding layer 6 can be a combination of one or more layers, with one or more materials.

According to an embodiment, the bonding layer 6 can comprise a bottom transparent conducting film, especially made of a transparent conductive oxide material (TCO or TCOs). For example, the transparent conducting film can be made of indium tin oxide (ITO) or of fluorine-doped tin oxide (FTO).

Such a conducting film is especially utilized for a thin cell 1 with a rear junction layer 2 made of silicon (silicium).

Such a conducting film is also utilized to avoid light reflection.

According to the invention, in order to obtain a very thin bonding layer 6 under requirements of transparency and conduction, and also a tolerance to roughness, the material of such a bonding layer 6 is a thin planar layer forming a bidimensional mesh (as the thickness is very low, compared to the other dimensions, namely the length and the width).

So, the material of the at least one bonding layer 6 comprises among a filler 8 a distribution of microscopic studs 10. Moreover, such a material is made of the filler 8 and the studs 10 linking the top of the at least one rear junction layer 2 and the bottom of the front junction layer 4. In other words, the bonding layer 6 is made of a micro-structured patterned material, conferring the roughness to fix the junctions layers 2,4 together, with all the requirements above mentioned.

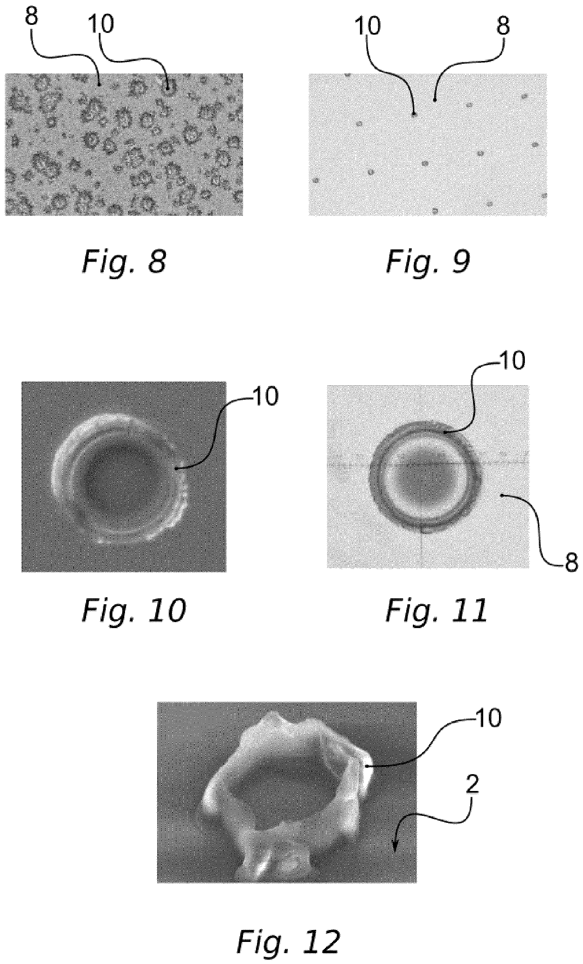

According to an embodiment, the microscopic studs 10 globally have a hollow tube shape. In other words, the studs 10 have approximately a cylindrical shape, with a circular or ovoidal transverse section. An example of circular section studs 10 is shown in figures 10 and 11.

Such a hollow tube shape is especially obtained through a specific production method, such as described below.

According to another embodiment, the studs 10 can also have a geometrical transverse cross section, especially a square or rectangular cross section.

Moreover, the studs 10 can have a regular or irregular shape. An example of tubular studs 10 with irregular shape is shown in figure 12.

The studs 10 can extend vertically or be inclined relative to the vertical (i.e. orthogonally regarding the plane comprising the layers 2,4,6).

So the studs 10 create conductive canals between the rear junction layer 2 and the front junction layer 4.

According to an embodiment, the studs 10 are microscopic, so they cannot be seen with the human eye (i.e. macroscopic) or without a dedicated optical device. Especially, the studs 10 globally have a height comprised between 1 micron (µm) and 100 microns (µm).

According to an embodiment, the microscopic studs 10 globally have a diameter up to 200 microns (µm), preferably less than 100 microns (µm), more preferably around 50 microns (µm).

It is to be noted that the studs 10 can have different shapes and diameters.

According to an embodiment, the studs 10 can be located among the filler8 in various positions.

Especially, the distribution of the microscopic studs 10 can be regular, with a matrix configuration. In other words, the studs 10 are located along rows and columns.

According to an embodiment, the microscopic studs 10 in the matrix configuration distribution have a spacing less than 1 millimeter (mm)), preferably between 100 microns (µm) and 200 microns (µm).

In another configuration, the distribution of the microscopic studs 10 can be irregular, the microscopic studs 10 being randomly distributed among the filler.

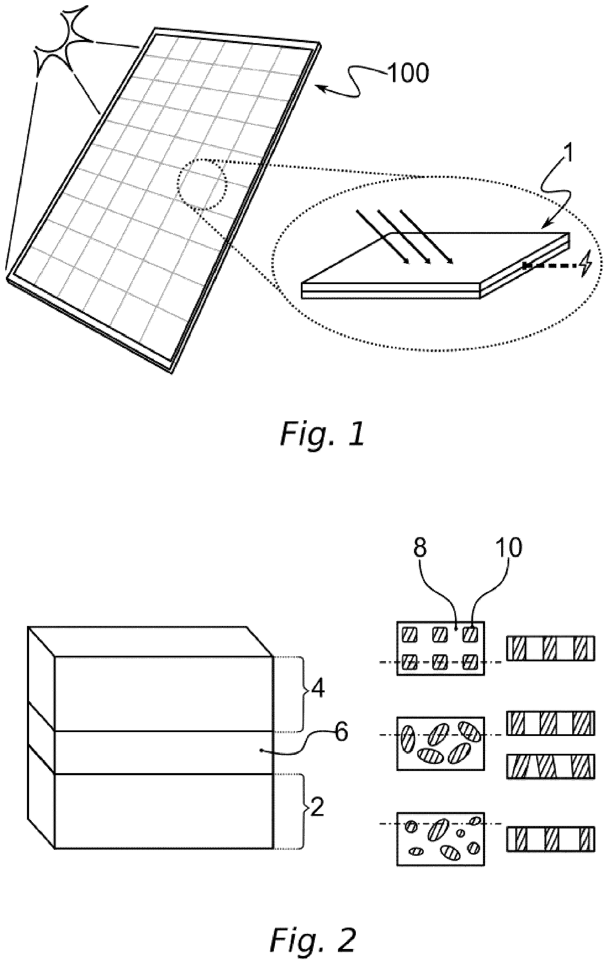

Different distributions of the studs 10 are shown in figure 2.

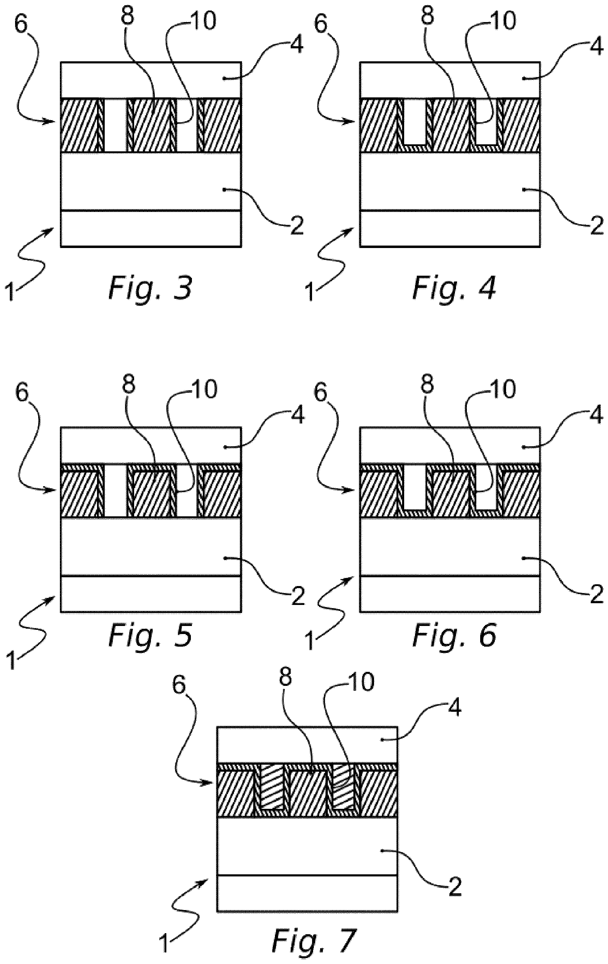

According to an embodiment, such as shown in figure 3, each of the studs 10 globally has a tubular shape, so that such a stud 10 comprises one or more peripheral walls but is hollow inside. In other words, the filler 8 is located around the studs 10 and no filler 8 is comprised inside the studs 10.

Thus, each of the studs 10 creates an empty canal between the top of the rear junction layer 2 and the bottom of the front junction layer 4.

According to an embodiment, such as shown in figure 4, the bottom end inside the hollow tube shape studs 10 is covered with the same material as the material of the studs 10. In other words, the stud 10 is closed at the bottom (i.e. with a vertical cross section with a globally U shape).

According to an embodiment, such as shown in figure 5, the top ends of the hollow tube shape studs 10 are linked by a coating with the same material as the material of the studs 10. In other words, the tops of the studs 10 are linked together over the filler 8. So the studs 10 are still hollow inside, but are connected with a thin film layer above the filler 8.

According to an embodiment, such as shown in figure 6, the two above embodiments can be combined. So the bottom end inside the hollow tube shape studs 10 is covered with the same material as the material of the studs 10, and the top ends of the hollow tube shape studs 10 are linked by a coating of the same material as the material of the studs 10.

According to an embodiment, the material of the studs 10 is made of PEDOT or PEDT (Poly(3,4-ethylenedioxythiophene)), especially made of PEDOT:PSS (PEDOT + sodium polystyrene sulfonate)).

According to an embodiment, the material of the studs 10 can comprise one or more additive(s). For example, the material of the studs 10 can comprise an additive for low temperature crystallization, as PEDGE (Poly(ethylene glycol) diglycidyl ether) or for increasing conductivity, as ethanol or DMSO (Dimethyl sulfoxide).

According to an embodiment, such as shown in figure 7, the inside of the hollow tube shape of the studs 10 is filled with a transparent material, which is conductive or non-conductive, preferably with the same material as the filler 8.

According to an embodiment, the filler 8 between the studs 10 comprises a non-conductive and transparent material, preferably made of PMMA (poly methyl methacrylate acrylic) or PDMS (polydimethylsiloxane). Also, the filler 8 could be made of a fluid or a gas material, such as the air or a specific gas.

According to an embodiment, the filler 8 comprises a material of a light-sensitive mix (photoresist) that can be microscopically patterned.

The invention also relates to different processes to produce the tandem cell 1 according to any of the preceding embodiments.

A first process is a production method of the tandem photovoltaic cell 1, comprising the steps of define the microscopic stud distribution by printing the microscopic stud distribution with PEDOT:PSS; then treating the printed surface by a soft crystallization technique; and then bonding the corresponding top of the rear junction layer 2 or bottom of the front junction layer 4.

According to an embodiment, the production method comprises the step of defining the microscopic filler distribution by printing the microscopic stud distribution on the bottom of the front junction layer 4 or on the top of the rear junction layer 2 with a polymer material, such as PMMA, PDMS, or a photoresist material. Especially, the studs 10 are holes defined in the polymer material of the filler 8.

Then, the pattern is printed with PEDOT:PSS.

Then, the microscopic stud distribution is printed on the bottom of the front junction layer 4 or on the top of the rear junction layer 2 with PEDOT:PSS.

Then, optionally, the microscopic stud configuration is coated with PMMA, PDMS or PGMEA into a coated surface.

Then, the printed (or coated) surface is treated by a soft crystallization technique with low temperatures comprised between 0°C and 200°C.

Finally, the production method comprises the step of bonding the corresponding top of the rear junction layer 2 or bottom of the front junction layer 4.

According to an embodiment, the printing consists in a lithography technique or an inkjet technique.

According to an embodiment, the production method further optionally comprises a lift-off of the coated surface by removing the filler 8 through immersion in a compatible solvent chosen from acetone, EtOH or similar, to create a stud surrounded by air.

According to a second process, the production method of the tandem photovoltaic cell 1 comprises the step of applying a mixed material of PEDOT:PSS with a mix comprising a polymer such as PMMA, PDMS, diluted in a solvent such as toluene, or PGMEA, on the bottom of the front junction layer or on the top of the rear junction layer.

Then, the mix comprising the PEDOT:PSS, the filler 8 such as PMMA,PDMS diluted in a solvent such as toluene or PGMEA is coated on the top of the rear junction layer 2 or on the bottom of the front junction layer 4.

Then, to obtain the coated surface, the solvent is evaporated to create the microscopic stud distribution, through spreading the coating and/or applying a heating technique (for example: a heating between 100°C and 150°C). With such a way, the microscopic studs 10 are randomly distributed or they are self-organized in the distribution.

Then, the coated surface is treated by a soft crystallization technique at low temperatures comprised between 0°C and 200°C; and then bonding the corresponding top of the rear junction layer 2 or bottom of the front junction layer 4.

According to a third process, the stud distribution is created in a random pattern.

Therefore, the production method of the tandem photovoltaic cell 1 comprises several the steps.

First, a step comprises applying a mixed material of two polymers, such as PMMA, PS or PDMS, diluted in a solvent, such as PGMEA or toluene, on the bottom of the front junction layer 4 or on the top of the rear junction layer 2.

Then, the solvent is evaporated in order to create the microscopic distribution. The step of evaporating is obtained through spreading the coating and/or applying a heating technique.

Then, one polymer is selectively removed such as PMMA or PS, using a selective solvent. Such a selective solvent can be acetic acid or cyclohexanene.

Such a step is another lithography technique which not based on inkjet or light exposure. It uses two polymers, for example PMMA and PS, to create and obtain a random or self-organized pattern, for example in PMMA, after removing the PS. Then the mix is coated with PEDOT:PSS and then bonding.

Then, the random pattern is coated with PEDOT:PSS, in order to obtain a coated surface.

Then, the coated surface is treated by a soft crystallization technique at low temperatures comprised between 0°C and 200°C.

Finally, the production method comprises the step of bonding the corresponding top of the rear junction layer 2 or bottom of the front junction layer 4.

## Claims

1. Tandem photovoltaic cell (1), comprising
- at least one rear junction layer (2) with a first light absorption spectrum associated with a first type of photon;
- at least one front junction layer (4) with a second light absorption spectrum associated with a second type of photon;
- at least one bonding layer (6) located between the at least one rear junction layer (2) and the at least one front junction layer (4),
a bottom surface of the at least one bonding layer (6) bonding a top of the at least one rear layer (2),
a top surface of the at least one bonding (6) layer bonding a bottom of the at least one front layer (4),
the at least one bonding layer (6) being of a transparent and conductive material, **characterized in that**
- the material of the at least one bonding layer (6) comprises among a filler (8) a distribution of microscopic studs (10) linking the top of the at least one rear junction layer (2) and the bottom of the front junction layer (4).

2. Tandem photovoltaic cell (1) according to the preceding claim, **characterized in that**
- the microscopic studs (10) globally have a hollow tube shape.

3. Tandem photovoltaic cell (1) according to the preceding claims, **characterized in that**
- the microscopic studs (10) globally have a height comprised between 1 micron (µm) and 100 microns (µm).

4. Tandem photovoltaic cell (1) according to claim 2 or claim 3, **characterized in that**
- the microscopic studs (10) globally have a diameter up to 200 microns (µm), especially less than 100 microns (µm), preferably around 50 microns (µm).

5. Tandem photovoltaic cell (1) according to any of the preceding claims, **characterized in that**
- the microscopic stud distribution is regular with a matrix configuration.

6. Tandem photovoltaic cell (1) according to the preceding claim, **characterized in that**
- the microscopic studs (10) of the matrix configuration distribution have a spacing less than 1 millimeter (mm), preferably between 100 microns (µm) and 200 microns (µm).

7. Tandem photovoltaic cell (1) according to claims 1 to 4, **characterized in that**
- the microscopic stud distribution is irregular, the microscopic studs (10) being randomly distributed among the filler (8).

8. Tandem photovoltaic cell (1) according to claims 2 to 7, **characterized in that**
- the inside of the hollow tube shape of the studs (10) is filled with a transparent material, which is conductive or non-conductive, preferably with the same material as the filler (8).

9. Tandem photovoltaic cell (1) according to any of the preceding claims, **characterized in that**
- the filler (8) between the studs (10) comprises a non-conductive and transparent material, preferably made of PMMA or PDMS or photoresist.

10. Tandem photovoltaic cell (1) according to any of the preceding claims, **characterized in that**
- the material of the microscopic studs (10) is PEDOT:PSS.

11. Photovoltaic panel (100), comprising
- at least one module for generating electricity by converting sunlight,
**characterized in that**
- each module comprising several tandem photovoltaic cells (1) according to any of the preceding claims, the tandem photovoltaic cells (1) being arranged side by side.

12. Production method of the tandem photovoltaic cell (1) according to any of the claims 1 to 10, comprising the steps of:
- defining the microscopic stud distribution by printing the microscopic stud distribution on the bottom of the front junction layer (4) or on the top of the rear junction layer (2) with a polymer material, such as PMMA, PDMS, or a photoresist material;
- coating the pattern with PEDOT:PSS;
- printing the microscopic stud distribution on the bottom of the front junction layer (4) or on the top of the rear junction layer (2) with PEDOT:PSS;
- treating the printed surface by a soft crystallization technique with low temperatures comprised between 0°C and 200°C (degree Celsius);
- bonding the corresponding top of the rear junction layer (2) or bottom of the front junction layer (4).

13. Production method according to the preceding claim, further comprising
- a lift-off of the coated surface by removing the filler (8) through immersion in a compatible solvent chosen from acetone, EtOH or similar, to create a stud (10) surrounded by air.

14. Production method of the tandem photovoltaic cell (1) according to any of the claims 1 to 10, comprising the steps of:
- applying a mixed material of PEDOT:PSS with a solvent, such as PMMA, PDMS, diluted in toluene, or PGMEA, on the bottom of the front junction layer (4) or on the top of the rear junction layer (2);
- coating the mixed material on the top of the rear junction layer (2) or on the bottom of the front junction layer (4);
- to obtain the coated surface, evaporate the solvent to create the microscopic stud distribution, through spreading the coating and/or applying a heating technique;
- treating the coated surface by a soft crystallization technique at low temperatures comprised between 0°C and 200°C;
- bonding the corresponding top of the rear junction layer (2) or bottom of the front junction layer (4).

15. Production method of the tandem photovoltaic cell (1) according to any of the claims 1 to 10, comprising the steps of:
- applying a mixed material of two polymers, such as PMMA, PS or PDMS, diluted in a solvent, such as PGMEA or toluene, on the bottom of the front junction layer (4) or on the top of the rear junction layer (2);
- evaporate the solvent to create the microscopic stud distribution, through spreading the coating and/or applying a heating technique;
- remove selectively one of the two transparent polymers with a selective solvent;
- coating the random pattern with PEDOT:PSS into a coated surface;
- treating the coated surface by a soft crystallization technique at low temperatures comprised between 0°C and 200°C;
- bonding the corresponding top of the rear junction layer (2) or bottom of the front junction layer (4).
